# EUROPEAN PATENT SPECIFICATION

(11) **EP 2 390 674 B1**
(45) Date of publication and mention of the grant of the patent: **18.02.2015**
(21) Application number: 11167279.6
(22) Date of filing: 24.05.2011
(51) Int. Cl.: G01R 31/02, G01R 31/28

(54) **Air conditioner**
Klimaanlage
Climatiseur

(30) Priority: 27.05.2010 JP 2010121526
(43) Date of publication of application: 30.11.2011
(73) Proprietor: SANYO Electric Co., Ltd., Moriguchi City Osaka 570-8677 (JP)
(72) Inventor: Suzuki, Kentaro, Moriguchi City Osaka 570-8677 (JP); Suzuki, Junichi, Moriguchi City Osaka 570-8677 (JP)
(74) Representative: Glawe, Delfs, Moll

(56) References cited:
- JP-A- 2005 304 129
- US-A1- 2004 057 170

## Description

### BACKGROUND OF THE INVENTION

The present invention relates to an air conditioner which receives power supply from a three-phase four-wire system alternating current power source.

Conventionally, one of this type of air conditioners is operated by being supplied with electric power from a three-phase four-wire system alternating current power source having an N phase. In such an air conditioner, when abnormality of the power source connection state is detected, zero cross waveforms between phases of the power source are generated, and the waveforms are input to a controller (control means). Thus, abnormality such as a phase loss is detected from a phase difference among the waveforms (for example, see Jpn. Pat. Appln. KOKAI Publication No.2005-304129).

However, when the N phase of a power source is lost, such a phase difference as to enable the detection of the clear abnormality is not generated owing to the influence of a capacitor on the circuit, unless power consumption of the power source including the N phase (for example, between L1 phase and N phase) is large.

Further, another type of the air conditioners mounts a crank case heater to heat a compressor. In this type of conditioner, to detect abnormality such as breakage, it is only one way to confirm temperature rise of the compressor by use of, for example, a temperature sensor. In this way, however, it is difficult to detect the abnormality without fail, because an abnormality detection reference based on the temperature rise varies depending on an operation status of the compressor and ambient temperature conditions.

US 2004/0057170 A1 discloses a system for detecting loss of an electrical phase in a compressor including a plurality of phase carrying legs. The detection system further comprises a sensor for measuring current communicated with one of the phase carrying legs, and a processor adapted to receive a signal from the sensor and to determine whether a loss of phase has occurred.

### SUMMARY OF THE INVENTION

The present invention has been made in order to solve the above-mentioned conventional technical problems, and an object the present invention is to enable accurate detection of N phase loss in an air conditioner which receives power supply from a three-phase four-wire system alternating current power source.

For the solution of the above-mentioned problems, a first aspect of the invention is directed to an air conditioner which receives power supply from a three-phase four-wire system alternating current power source and which comprises a crank case heater connected between an N phase and a phase other than the N phase of the alternating current power source; a first current transformer and a second current transformer provided respectively to detect an electric current which flows through the N phase and the phase other than the N phase; and control means to control a compressor, and connected to the output of a secondary winding wire of each current transformer and to the alternating current power source, wherein a winding number of the secondary winding wire of the first current transformer is larger than that of the secondary winding wire of the second current transformer, and the control means determines that the N phase is lost or the electric load is abnormal, if the output of the first current transformer is smaller than that of the second current transformer or the output of the first current transformer does not reach a predetermined value, based on the outputs of the respective current transformers during energizing the crank case heater, in a state where the compressor stops.

A second aspect of the invention is directed to the above air conditioner wherein the winding number of the secondary winding wire of the first current transformer is set so that the output of the secondary winding wire of the first current transformer is greater than the output of the secondary winding wire of the second current transformer by a power consumption of the crank case heater.

An air conditioner according to the first aspect of the present invention receives power supply from a three-phase four-wire system alternating current power source and comprises a crank case heater connected between an N phase and a phase other than the N phase of the alternating current power source, a first current transformer and a second current transformer provided respectively to detect an electric current which flows through the N phase and the phase other than the N phase, and control means to control a compressor which is connected to the output of a secondary winding wire of each current transformer and which is connected to the alternating current power source, wherein a winding number of the secondary winding wire of the first current transformer is larger than that of the secondary winding wire of the second current transformer. Thus, the output of the first current transformer reaches a predetermined value and is larger than that of the second current transformer, if the N phase is not lost or any abnormality does not occur in the crank case heater during energizing the crank case heater, in a state where the compressor stops.

On the other hand, if the N phase is lost or an abnormality occurs in the crank case heater, the output of the first current transformer is smaller than the predetermined value and does not reach that of the second current transformer.

According to the present invention, the control means is configured to determine that the N phase is lost or the electric load is abnormal, if the output of the first current transformer is smaller than that of the second current transformer or the output of the first current transformer does not reach the predetermined value, based on the outputs of the current transformers during energizing the crank case heater, in the state where the compressor stops. Therefore, it is possible to accurately detect the loss of the N phase or the abnormality of the crank case heater connected between the N phase and the phase other than the N phase, which detection has been difficult by the conventional method utilizing a phase difference.

In particular, the winding number of the secondary winding wire of the first current transformer is made larger than that of the secondary winding wire of the second current transformer, and therefore, it is possible to use the same software for a peripheral circuit configuration to input the outputs of both the current transformers to the control means and the control means.

In this case, when the winding number of the secondary winding wire of the first current transformer is set so that the output of the secondary winding wire of the first current transformer is greater than that of the secondary winding wire of the second current transformer by the power consumption of the electric load as in the second aspect of the invention, it is possible to securely detect the loss of the N phase and the abnormality of the electric load.

It is possible to accurately detect even the abnormality of the crank case heater, which has heretofore been difficult. Further, the crank case heater is energized while the compressor stops, and therefore, it is possible to detect the loss of the N phase or the abnormality of the crank case heater, after turning on the alternating current power source and before activating the compressor.

### BRIEF DESCRIPTION OF THE DRAWINGS

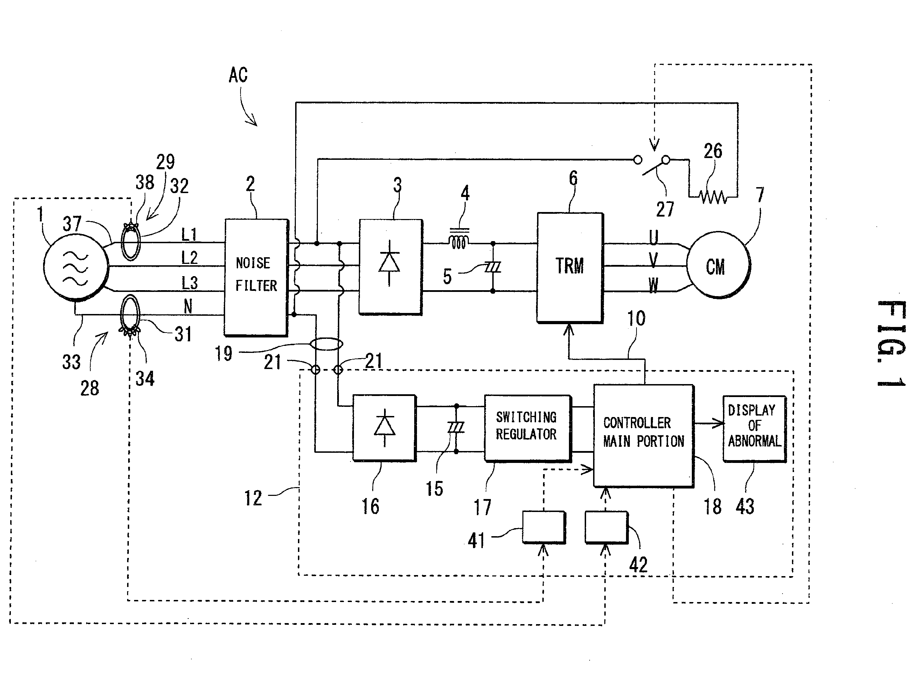

Fig. 1 is an electric circuit diagram of an air conditioner to which the present invention is applied.

### DETAILED DESCRIPTION OF THE PREFERRED EMBODIMENT

Embodiments of the present invention will be explained below in detail. In Fig. 1, an air conditioner AC in an embodiment adjusts compression performance of a compressor (electrical device connected to an alternating current power source 1) by varying a drive power source frequency in a range of, for example, 15 Hz to 100 Hz according to an air conditioning load and the variable control of the drive power source frequency is performed by a controller (control means) 12 built in the air conditioner AC.

Three-phase alternating current power (L1 phase to L3 phase) supplied from the three-phase four-wire system alternating current power source 1 having an N phase is given to a noise filter 2. The noise filter 2 is an LC integral type noise filter including a reactor and capacitor and removes noise (particularly, high frequency noise) included in the supply power from the alternating current power source 1 and outputs the alternating current power to a rectification circuit 3. The rectification circuit 3 is a three-phase bridge rectification circuit including a diode and converts the supplied alternating current power into direct current power.

The converted direct current power is supplied to a transistor module 6 after ripple components are removed by a smoothing circuit including a reactor 4 and a smoothing capacitor 5. The transistor module 6 generates alternating current power of a predetermined frequency from the supplied direct current power under PWM control in accordance with a control signal sent from the controller 12 (a controller main portion 18 which will be described later) via a control signal line 10, to drive a compressor motor of the compressor 7.

A power source terminal 21 of the controller 12 is wired so that alternating current power between the N phase and the L1 phase is supplied from an output end of the noise filter 2 via a power source wire 19. Via the noise filter 2, the alternating current power is converted into direct current power by a rectification circuit 16. As the rectification circuit 16, a bridge rectification circuit including a diode is used. The direct current power converted by the rectification circuit 16 is smoothed in a smoothing capacitor 15, and then sent to a switching regulator 17 to improve regulation, that is, to accomplish stabilization. Then, the thus stabilized current power is provided to the power source of the controller main portion 18 (a microcomputer constituting the controller 12 which is the control means) of the controller 12. As the switching regulator 17, there is utilized a self-oscillation type using, for example, a high frequency transformer.

Between the N phase and the L1 phase on the output end side of the noise filter 2, a serial circuit of a crank case heater 26 and a switch 27 is further connected, as an embodiment of the electric load (an electrical device connected to the alternating current power source 1) of the present invention. The crank case heater 26 is a heater configured to be energized while the compressor 7 stops to heat the compressor 7, thereby separating and evaporating a liquid refrigerant dissolved in the oil of a refrigerator, to operate the compressor 7. If the compressor 7 is operated in a state where the wire of the crank case heater 26 is broken, liquid compression occurs to cause a problem such as a damage of the compressor 7. Then, opening/closing of the switch 27 is controlled by the controller main portion 18 of the controller 12. The controller 12 closes the switch 27 while the compressor 7 stops, to energize the crank case heater 26. In consequence, the crank case of the compressor 7 is heated to prevent the occurrence of the liquid compression.

On the other hand, in the N phase and the L1 phase (phase to which the crank case heater 26 is connected) of the alternating current power source 1 on the input end side of the noise filter 2, a first current transformer 28 and a second current transformer 29 are provided, respectively. The current transformers 28, 29 each have annular magnetic cores 31, 32 and the power source line of the N phase penetrates through the annular magnetic core 31 of the first current transformer 28 as a primary conductor 33 and a secondary winding wire 34 to take out an electric signal is wound around the annular magnetic core 31. Further, the power source line of the L1 phase penetrates through the annular magnetic core 32 of the second current transformer 29 as a. primary conductor 37 and a secondary winding wire 38 to take out an electric signal is wound around the annular magnetic core 32.

In particular, in the present invention, the winding number of the secondary winding wire 34 of the first current transformer 28 is made larger than that of the secondary winding wire 38 of the second current transformer 29. In this case, it is assumed that the winding number of the secondary winding wire 34 is set so that the output of the secondary winding wire 34 of the first current transformer 28 is greater than the output of the secondary winding wire 38 of the second current transformer 29 by power consumption in the crank case heater 26 which is energized while the compressor 7 stops.

Then, the output of each of the secondary winding wires 34, 38 is connected to the controller main portion 18 via electric current detection signal waveform shaping circuits 41, 42 respectively of the controller 12 The electric current detection signal waveform shaping circuits 41, 42 convert the electric current (output) which flows through each of the secondary winding wires 34, 38 into a voltage and inputs it to the controller main portion 18. Here, when the compressor 7 is operated, an amount of electric current which flows through the second current transformer 29 to detect the electric current of the L1 phase is by far larger than that of electric current which flows through the crank case heater 26, and therefore, if the winding number of the secondary winding wires 34, 38 of both the current transformers 28, 29 is the same, it is no longer possible for the controller main portion 18 to determine the change in output of the first current transformer 28 with the peripheral circuit and software for the second current transformer 29 and a special peripheral circuit and software for the first current transformer 28 are necessary.

However, in the present invention, the winding number of the secondary winding wire 34 of the first current transformer 28 is made larger than that of the secondary winding wire 38 of the second current transformer 29, and therefore, it will cause no trouble even if the same peripheral circuit configuration of the controller 12 to input the output of both the current transformers 28, 29 and the same software of the controller main portion 18 are used for both the current transformers 28, 29. To the controller main portion 18 of the controller 12, a display of abnormal 43 (including an LED etc.) as a warning means is connected.

In accordance with the above-mentioned configuration, there will be explained a detection operation of the N phase loss abnormality in the alternating current power source 1 and the breakage abnormality of the crank case heater 26 in the present invention. In a state where the alternating current power source 1 is turned on and the compressor 7 (including a fan motor, not shown schematically) which accounts for almost all the power consumption of the air conditioner AC stop, the controller main portion 18 of the controller 12 closes the switch 27 and energizes the crank case heater 26. When the N phase is not lost (the primary conductor 33, which is the power source line of the N phase, is not dislocated) and there is no breakage in the crank case heater 26, by closing the switch 27, an electric current between the L1 phase and the N phase of the alternating current power source 1 flows through the crank case heater 26 and the crank case heater 26 generates heat.

In this case, as described above, the winding number of the secondary winding wire 34 of the first current transformer 28 is made larger than that of the secondary winding wire 38 of the second current transformer 29 and the winding number of the secondary winding wire 34 is set so that the output of the secondary winding wire 34 is greater than the output of the secondary winding wire 38 by the power consumption of the crank case heater 26, and therefore, the output of the secondary winding wire 34 of the first current transformer 28 to be input to the controller main portion 18 of the controller 12 becomes greater than a predetermined value (set in advance in the controller main portion 18) and greater than the output of the secondary winding wire 38 of the second current transformer 29. In this case, the controller main portion 18 determines that the N phase loss abnormality or the breakage abnormality of the crank case heater 26 has not occurred.

On the other hand, when the N phase of the alternating current power source 1 is lost or when breakage occurs in the crank case heater 26, the crank case heater 26 does not generate heat even if the switch 27 is closed, and therefore, the output of the secondary winding wire 34 of the first current transformer 28 no longer reaches the predetermined value. Further, when there is no breakage in the crank case heater 26 but the N phase is lost, despite that the N phase is lost, if the switch 27 is closed, an electric current flows through the primary conductor 37 of the second current transformer 29, which is the power source line of the L1 phase, by the influence of power charged in the capacitor in the electric circuit etc. and an output is generated in the secondary winding wire 38 of the second current transformer 29. However, if the N phase is lost, no electric current flows through the primary conductor 33 of the first current transformer 28, which is the power source line of the N phase, and therefore, no output is generated in the secondary winding wire 34 of the first current transformer 28 and consequently the output of the secondary winding wire 34 of the first current transformer 28 becomes smaller than the output of the secondary winding wire 38 of the second current transformer 29.

Because of the above, the controller main portion 18 of the controller 12 determines that the N phase of the alternating current power source 1 is lost or there is breakage in the crank case heater 26 and inhibits the activation of the compressor 7 as well lighting the display of abnormal 43 to issue warning when the switch 27 is closed to energize the crank case heater 26 while the compressor 7 stops and if the output of the secondary winding wire 34 of the first current transformer 28 is smaller than the output of the secondary winding wire 38 of the second current transformer 29 or the output of the secondary winding wire 34 of the first current transformer 28 does not reach the predetermined value.

As described above, the controller main portion 18 of the controller 12 determines that the N phase is lost or the crank case heater 26 is abnormal, if the output of the first current transformer 28 is smaller than that of the second current transformer 29 or the output of the first current transformer 28 does not reach the predetermined value, based on the output of each of the current transformers 28, 29 during energizing the crank case heater 26 (electric load), in a state where the compressor 7 (electrical device) stops. Therefore, it is possible to accurately detect the loss of the N phase and the abnormality of the crank case heater 26 connected between the N phase and the L1 phase other than the N phase, which detection has been difficult by the conventional method utilizing the phase difference.

In particular, the winding number of the secondary winding wire 34 of the first current transformer 28 is made larger than that of the secondary winding wire 38 of the second current transformer 29, and therefore, it is possible to make the same the peripheral circuit configuration of the electric current detection signal waveform shaping circuits 41, 42 to input the output of both the current transformers 28, 29 to the controller main portion 18 etc. and the software of the controller main portion 18.

In this case, the winding number of the secondary winding wire 34 of the first current transformer 28 is set so that the output of the secondary winding wire 34 of the first current transformer 28 is greater than the output of the secondary winding wire 38 of the second current transformer 29 by the power consumption of the crank case heater 26, and therefore, it is possible to securely detect the N phase loss and abnormality of the crank case heater 26.

Further, the crank case heater 26 is energized while the compressor 7 stops, and therefore, it is possible to detect the N phase loss or abnormality of the crank case heater 26 before activating the compressor 7 after turning on the alternating current power source 1.

## Claims

1. An air conditioner which receives power supply from a three-phase four-wire system alternating current power source (1), the air conditioner comprising:
a crank case heater (26) connected between an N phase and a phase other than the N phase of the alternating current power source (1);
a first current transformer (28) and a second current transformer (29) provided respectively to detect an electric current which flows through the N phase and the phase other than the N phase; and
control means (12) to control a compressor (7), and connected to the output of a secondary winding wire of each current transformer and to the alternating current power source(1),
wherein the winding number of the secondary winding wire (34) of the first current transformer (28) is larger than that of the secondary winding wire (38) of the second current transformer (29); and
wherein the control means (12) is adapted to determine that the N phase is lost or the crank case heater (26) is abnormal, if the output of the first current transformer (28) is smaller than that of the second current transformer (29) or the output of the first current transformer (28) does not reach a predetermined value, based on the outputs of the respective current transformers during energizing the crank case heater (26), in a state where the compressor (7) stops.

2. The air conditioner according to claim 1, wherein the winding number of the secondary winding wire (34) of the first current transformer (28) is set so that the output of the secondary winding wire (34) of the first current transformer (28) is greater than the output of the secondary winding wire (38) of the second current transformer (29) by a power consumption of the crank case heater (26).

## Patentansprüche

1. Klimaanlage, die Stromversorgung aus einer dreiphasigen Vierdrahtsystem-Wechselstromquelle (1) empfängt, wobei die Klimaanlage folgendes umfasst:
eine Kurbelgehäuseheizung (26), die zwischen einer N-Phase und einer anderen Phase als der N-Phase der Wechselstromquelle (1) angeschlossen ist;
einen ersten Stromwandler (28) und einen zweiten Stromwandler (29), die jeweils vorgesehen ist, um einen elektrischen Strom zu erfassen, der durch die N-Phase und die andere Phase als die N-Phase fließt, und
Steuermittel (12) zum Steuern eines Kompressors (7) und verbunden mit dem Ausgang eines Sekundärwicklungsdrahts von jedem Stromwandler und mit der Wechselstromquelle (1),
wobei die Wicklungszahl des Sekundärwicklungsdrahts (34) des ersten Stromwandlers (28) größer als jene des Sekundärwicklungsdrahts (38) des zweiten Stromwandlers (29) ist; und
wobei das Steuermittel (12) eingerichtet ist, zu bestimmen, dass die N-Phase verloren ist oder die Kurbelgehäuseheizung (26) abnorm ist, wenn die Ausgangsleistung des ersten Stromwandlers (28) kleiner ist als jene des zweiten Stromwandlers (29) oder die Ausgangsleistung des ersten Stromwandlers (28) einen vorgegebenen Wert nicht erreicht, basierend auf den Ausgangsleistungen der jeweiligen Stromwandler während des Einschaltens der Kurbelgehäuseheizung (26), in einem Zustand, wenn der Kompressor (7) stoppt.

2. Klimaanlage gemäß Anspruch 1, wobei die Wicklungszahl des Sekundärwicklungsdrahts (34) des ersten Stromwandlers (28) so festgelegt ist, dass die Ausgangsleistung des Sekundärwicklungsdrahts (34) des ersten Stromwandlers (28) größer als die Ausgangsleistung des Sekundärwicklungsdrahts (38) des zweiten Stromwandlers (29) durch einen Energieverbrauch der Kurbelgehäuseheizung (26) ist.

## Revendications

1. Climatiseur qui reçoit une alimentation d'une source de puissance alternative de système triphasé à quatre fils (1), le climatiseur comprenant :
un dispositif de chauffage de carter (26) connecté entre une phase N et une phase autre que la phase N de la source de puissance alternative (1) ;
un premier transformateur de courant (28) et un deuxième transformateur de courant (29) prévus respectivement pour détecter un courant électrique qui circule à travers la phase N et la phase autre que la phase N ; et
des moyens de commande (12) pour commander un compresseur (7), et connectés à la sortie d'un fil d'enroulement secondaire de chaque transformateur de courant et à la source de puissance alternative (1),
dans lequel le nombre d'enroulements du fil d'enroulement secondaire (34) du premier transformateur de courant (28) est supérieur à celui du fil d'enroulement secondaire (38) du deuxième transformateur de courant (29) ; et
dans lequel les moyens de commande (12) sont conçus pour déterminer que la phase N est perdue ou que le dispositif de chauffage de carter (26) est dans un état anormal, si la sortie du premier transformateur de courant (28) est inférieure à celle du deuxième transformateur de courant (29) ou si la sortie du premier transformateur de courant (28) n'atteint pas une valeur prédéterminée, sur la base des sorties des transformateurs de courant respectifs pendant l'alimentation du dispositif de chauffage de carter (26), dans un état dans lequel le compresseur (7) s'arrête.

2. Climatiseur selon la revendication 1, dans lequel le nombre d'enroulements du fil d'enroulement secondaire (34) du premier transformateur de courant (28) est fixé de sorte que la sortie du fil d'enroulement secondaire (34) du premier transformateur de courant (28) soit supérieure à la sortie du fil d'enroulement secondaire (38) du deuxième transformateur de courant (29) d'une consommation de puissance du dispositif de chauffage de carter (26).
